(19) Europäisches Patentamt
European Patent Office
Office européen des brevets

(11) **EP 2 806 284 B1**

(12) **EUROPEAN PATENT SPECIFICATION**

(45) Date of publication and mention
of the grant of the patent:
**27.03.2019 Bulletin 2019/13**

(51) Int Cl.:
*G01R 33/561* (2006.01)  *G01R 33/48* (2006.01)
*G01R 33/483* (2006.01)  *G01R 33/565* (2006.01)

(21) Application number: **14172087.0**

(22) Date of filing: **22.04.2008**

(54) **MAGNETIC RESONANCE DEVICE AND METHOD FOR PROPELLER MRI**

MAGNETRESONANZVORRICHTUNG UND -VERFAHREN FÜR PROPELLER MRI

DISPOSITIF ET PROCÉDÉ DE RÉSONANCE MAGNÉTIQUE POUR L'IRM PROPELLER

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.04.2007 EP 07107078**

(43) Date of publication of application:
**26.11.2014 Bulletin 2014/48**

(62) Document number(s) of the earlier application(s) in accordance with Art. 76 EPC:
**08737949.1 / 2 145 199**

(73) Proprietors:
• **Koninklijke Philips N.V.**
  **5656 AE Eindhoven (NL)**
• **Philips Intellectual Property & Standards GmbH**
  **20099 Hamburg (DE)**

(72) Inventors:
• **Eggers, Holger**
  **5600 AE Eindhoven (NL)**
• **Nehrke, Kay**
  **5600 AE Eindhoven (NL)**
• **Boernert, Peter**
  **5600 AE Eindhoven (NL)**

(74) Representative: **van Velzen, Maaike Mathilde et al**
**Philips Intellectual Property & Standards**
**High Tech Campus 5**
**5656 AE Eindhoven (NL)**

(56) References cited:
**US-A- 5 754 046**     **US-A1- 2007 001 672**

• **PIPE JG, ZWART NR: "Variable pitch PROPELLER: Motion corrected multislab 3D MRI", PROCEEDINGS OF THE INTERNATIONAL SOCIETY FOR MAGNETIC RESONANCE IN MEDICINE, ISMRM, 13TH SCIENTIFIC MEETING AND EXHIBITION, MIAMI BEACH, FLORIDA, USA, 7-13 MAY 2005, 23 April 2005 (2005-04-23), page 2239, XP040594923,**
• **PIPE J G: "Motion correction with PROPELLER MRI: application to head motion and free-breathing cardiac imaging", MAGNETIC RESONANCE IN MEDICINE, ACADEMIC PRESS, DULUTH, MN, US, vol. 42, no. 5, 1 November 1999 (1999-11-01), pages 963-969, XP002207261, ISSN: 0740-3194**
• **NEHRKE K ET AL: "Golden angle PROPELLER MRI", PROCEEDINGS OF THE JOINT ANNUAL MEETING ISMRM-ESMRMB, BERLIN, GERMANY, 19-25 MAY 2007, 19 May 2007 (2007-05-19), page 1729, XP002494269,**
• **CHUANG T-C ET AL: "Data-sharing PROPELLER imaging for increased temporal resolution retaining spatial resolution and image contrast", PROCEEDINGS OF THE INTERNATIONAL SOCIETY FOR MAGNETIC RESONANCE IN MEDICINE, ISMRM 14TH SCIENTIFIC MEETING AND EXHIBITION, 6-12 MAY 2006, SEATTLE, USA, 6 May 2006 (2006-05-06), page 2954, XP002494270,**

- XIUQUAN JI ET AL: "An improved mri method for dynamic contrast-enhanced imaging of tumors", PROCEEDINGS OF THE 25TH. ANNUAL INTERNATIONAL CONFERENCE OF THE IEEE ENGINEERING IN MEDICINE AND BIOLOGY SOCIETY. CANCUN, MEXICO, SEPT. 17 20030917; 20030917 - 20030921 NEW YORK, NY : IEEE, US, vol. 1, 17 September 2003 (2003-09-17), pages 478-481, XP010693297, ISBN: 978-0-7803-7789-9
- MACLAREN JR ET AL: "TRELLIS MRI: A novel approach to motion correction", PROCEEDINGS OF THE INTERNATIONAL SOCIETY FOR MAGNETIC RESONANCE IN MEDICINE, ISMRM 14TH SCIENTIFIC MEETING AND EXHIBITION, 6-12 MAY 2006, SEATTLE, USA, 6 May 2006 (2006-05-06), page 3194, XP002494271,
- STEFANIE WINKELMANN ET AL: "An Optimal Radial Profile Order Based on the Golden Ratio for Time-Resolved MRI", IEEE TRANSACTIONS ON MEDICAL IMAGING, IEEE SERVICE CENTER, PISCATAWAY, NJ, US, vol. 26, no. 1, 1 January 2007 (2007-01-01), pages 68-76, XP011152669, ISSN: 0278-0062
- ARFANAKIS K ET AL: "k-space undersampling in PROPELLER imaging", MAGNETIC RESONANCE IN MEDICINE, 2005, pages 675-683, XP002494272,
- PIPE JG: "Improved in-plane motion correction for PROPELLER MRI", PROCEEDINGS OF THE INTERNATIONAL SOCIETY FOR MAGNETIC RESONANCE IN MEDICINE, 9TH SCIENTIFIC MEETING AND EXHIBITION, GLASGOW, SCOTLAND, UK, 21-27 APRIL 2001, 21 April 2001 (2001-04-21), page 743, XP002502663,
- YANQIU FENG ET AL: "New Algorithm for Extracting Motion Information from PROPELLER Data and Head Motion Correction in T1-Weighted MRI", ENGINEERING IN MEDICINE AND BIOLOGY SOCIETY, 2005. IEEE-EMBS 2005. 27TH ANNUAL INTERNATIONAL CONFERENCE OF THE SHANGHAI, CHINA 01-04 SEPT. 2005, PISCATAWAY, NJ, USA,IEEE, 1 September 2005 (2005-09-01), pages 1378-1381, XP010908032, ISBN: 978-0-7803-8741-6

# Description

## FIELD OF THE INVENTION

The invention relates to a device for magnetic resonance imaging (MRI) of a body placed in an examination volume.

Furthermore, the invention relates to a method for MRI and to a computer program for a magnetic resonance (MR) device.

## DESCRIPTION OF THE PRIOR ART

In MRI, pulse sequences consisting of RF pulses and switched magnetic field gradients are applied to an object (a patient) placed in a homogeneous magnetic field within an examination volume of an MR device. In this way, MR signals are generated, which are scanned by means of radio frequency (RF) receiving antennas in order to obtain information about the object and to reconstruct images thereof. Since its initial development, the number of clinically relevant fields of application of MRI has grown enormously. MRI can be applied to almost every part of the body, and it can be used to obtain important functional information about the human body. The pulse sequence, which is applied during an MRI scan, plays a significant role in the determination of the characteristics of the reconstructed image, such as location and orientation in the object, dimensions, resolution, signal-to-noise ratio, contrast, sensitivity for movements, et cetera. An operator of an MRI device has to choose the appropriate sequence and has to adjust and optimize its parameters for the respective application.

In the known so-called PROPELLER concept (Periodically Rotated Overlapping ParalEL Lines with Enhanced Reconstruction, see James G. Pipe: "Motion Correction With PROPELLER MRI: Application to Head Motion and Free-Breathing Cardiac Imaging", Magnetic Resonance in Medicine, vol. 42, 1999, pages 963-969), MR signals are acquired in k-space in $N$ strips, each consisting of $L$ parallel lines, corresponding to the $L$ lowest frequency phase-encoding lines in a Cartesian k-space sampling scheme. Each strip, which is also referred to as k-space blade, is rotated in k-space by an angle $\delta\varphi = 180°/N$, so that the total MR data set spans approximately a circle in k-space. If a data matrix having a diameter $M$ is desired, then $L$ and $N$ are, for instance, chosen so that $L \cdot N = M \cdot \pi/2$. One essential characteristic of PROPELLER is that a central circular portion in k-space, having a diameter $L$, is acquired for each k-space blade. This central portion can be used to reconstruct a low-resolution image for each k-space blade. These low-resolution images, or their k-space representations, are compared to each other to remove in-plane displacements and phase errors, which are due to patient motion. In addition, a suitable technique such as cross-correlation is employed to determine which k-space blades were acquired with significant through-plane displacement. As the MR signals are combined in k-space before the reconstruction of the final MR image, the MR data from k-space blades with the least amount of through-plane motion are preferentially used in regions in which the k-space blades overlap, so that artifacts arising from through-plane motion are reduced. The PROPELLER technique makes use of oversampling in the central portion of k-space in order to obtain an MR image acquisition technique that is robust with respect to motion of the examined patient during MR signal acquisition.

Chuang et al. (Proc. ISMRM, p. 295, 2006) propose a technique referred to as data-sharing PROPELLER which combines k-space blades with different contrast using the well-known 'keyhole'-concept for dynamic MRI.

Ji et al. (IEEE EMBS, p. 478-481, 2003) describe an improved MRI approach for dynamic contrast-enhanced imaging of tumors. In this approach, a new data acquisition scheme is employed which is principally based on PROPELLER. The k-space blades are rotated in a special order so that two consecutively acquired blades cover k-space in orthogonal directions.

In the article "TRELLIS MRI: A Novel Approach to Motion Correction " by MacLaren et al. (Proc. ISMRM, p. 3194, 2006) motion information is gained for corresponding motion correction by filling k-space using interleaved horizontal and vertical strips. The phase and frequency encoding directions are alternated so that the frequency encoding direction is always paralleling each strip. The motion of the imaged object is deduced after the acquisition of each strip. The corresponding motion correction is then performed by rotating each strip back to a fixed reference position and by appropriate phase-adjustment.

US 2007/0001672 A1 discloses a PROPELLER-based MRI method, wherein a high-pass convolution of each acquired k-space blade with a reference k-space blade is determined and converted to a $\delta$ function. In-plane motion of the imaged object during data acquisition is deduced from the $\delta$ function.

Pipe et al. (Proc. ISMRM, p. 743, 2001) likewise propose an improved in-plane motion correction scheme for PROPELLER MRI. Therein, a single k-space blade is initially chosen as a reference blade. All other acquired k-space blades are translated to the location of the reference blade and an averaged image is calculated. In a second iteration, all k-space blades are translated to match the averaged image.

Arfanakis et al. (Magn. Reson. Med., p. 675-683, 2005) propose to reduce the scan time for PROPELLER MRI by means of undersampling. Undersampling is performed by removing whole k-space blades from a conventional PROPELLER sampling scheme, by using asymmetric k-space blades and by taking advantage of Hermitian symmetries to fill-in missing data. Imaging time is significantly reduced in this way without causing image artifacts.

Pipe et al. (Proc. ISMRM, p. 2239, 2005) disclose a modified PROPELLER MRI technique combining the conventional PROPELLER acquisition scheme with quadratic encoding (together called Variable Pitch PROPELLER), providing the SNR benefits of a "multi-slab" 3D sequence along with the motion correction inherent in conventional PROPELLER. The employed quadratic encoding uses a constant-magnitude radio frequency pulse with a linear frequency sweep ("variable pitch") over the duration of the radio frequency excitation pulse in the presence of a gradient in the slice direction, this excites a slab with a resulting parabolic phase profile in the slice direction. The k-space blades of the PROPELLER acquisition are collected as a stack of overlapping 2D slices with center-to-center spacing.

SUMMARY OF THE INVENTION

One problem of the known PROPELLER concept is that a complete rejection of motion-corrupted k-space blades results in undersampling of the peripheral k-space regions and, hence, in a potentially degraded image quality.

Another problem associated with multi-slice PROPELLER imaging is that individual slices from a multi-slice PROPELLER acquisition may be misaligned. The reason for this is that PROPELLER cross-correlates repeatedly measured MR signals in the central k-space as a reference for motion correction. Typically a reference is chosen showing the most similarity to the central k-space data of the other blades. The reference data chosen in accordance with PROPELLER is thus not an absolute but a relative reference, which may cause misalignment of the individual slices. A retrospective alignment of the slices of a multi-slice MR scan is possible in principle, provided that adjacent slices show substantial similarity. This pre-requisite is questionable in general, however.

For an accurate MR image reconstruction, the known PROPELLER imaging method requires a weighting of the acquired k-space samples. This is usually referred to as sampling density compensation. To compute the weighting factors, an iterative approach is commonly taken. The weighting also permits a prioritization of MR signals according to various criteria, such as correlation measures of the cross-correlated k-space blades, in order to achieve the above-mentioned reduction of motion-induced image artifacts. This prioritization can be applied in k-space areas that are more densely sampled than actually required to support the selected field of view. A drawback of the known technique is that the usually taken iterative approach for computing the weighting factors is slow and sporadically instable, especially if a strong contrast weighting is applied

Therefore, it is readily appreciated that there is a need for an improvement of the known PROPELLER imaging concept. It is consequently an object of the invention to provide an MR device that enables a reduction of image artifacts and an improved efficiency with PROPELLER imaging.

According to a first aspect of the invention, a device for MRI according to claim 1 is disclosed Moreover, a method for MR imaging according to claim 2 and a computer program for an MR device according to claim 3 are disclosed.

The gist of the invention is the acquisition of a separate MR reference data set (approximately) from the circular central portion of k-space which is acquired for each k-space blade. The acquisition only from the central k-space portion implies that the MR reference data set forms a low-resolution image. The acquisition of this reference data set can be performed without a significant increase in total scan time. According to the invention, the data from the common central portion of the k-space blades is compared to the reference data set, in order to estimate and correct motion-induced displacements and phase errors. The idea behind this approach is to establish a common reference for all k-space blades for the purpose of motion estimation and correction. Since the MR reference data set is a three-dimensional volume data set, the technique of the invention ensures a proper alignment of all slices of a multi-slice PROPELLER measurement. The k-space blades are acquired for two or more parallel image slices spaced in a direction perpendicular to the plane of rotation of the k-space blades. The common reference provided in accordance with the invention avoids misalignment of the image slices even if there is no significant similarity between adjacent slices of the multi-slice acquisition.

According to a second aspect which does not form part of the present invention, an MR device for MRI of a body placed in an examination volume is disclosed, which comprises means for establishing a substantially homogeneous main magnetic field in the examination volume, means for generating switched magnetic field gradients superimposed upon the main magnetic field, means for radiating RF pulses towards the body, control means for controlling the generation of the magnetic field gradients and the RF pulses, means for receiving and sampling MR signals, and reconstruction means for forming MR images from the signal samples. The invention proposes that the MR device is arranged to

    a) generate a series of MR signals by subjecting at least a portion of the body to an MR imaging sequence of at least one RF pulse and switched magnetic field gradients,
    b) acquire a plurality of k-space blades according to the PROPELLER scheme, the k-space blades being rotated about a center of k-space, wherein the rotation angle of the k-space blades is incremented during MR signal acquisition by an angle larger than $180°/N$, $N$ being the total number of k-space blades acquired, and
    c) reconstruct an MR image from the acquired MR signals.

The features of this second aspect of the invention can advantageously be combined with the features of the above-described first aspect of the invention.

The second aspect is based on the recognition of the fact that a regular angular undersampling produces only minimal image artifacts. Hence, the least artifacts can be expected if motion-corrupted k-space blades are distributed as uniformly as possible over the circle spanned by the rotated k-space blades. Since the angle is incremented by an angle larger than 180°/*N*, an interleaved arrangement of successively acquired k-space blades is achieved. The regular angular undersampling is more robust for image reconstruction than the omission of several motion-corrupted adjacent k-space blades which is characteristic for the conventional linear order of blades.

Preferably, the MR device according to the second aspect is further arranged to increment the angle of the k-space blades by the Golden Angle of 137,51° or by the half Golden Angle of 68,75°. According to this, the so-called Golden Angle principle is applied to PROPELLER MRI to generate an interleaved spatiotemporal order of k-space blades. The Golden Angle is the angle created by dividing the circumference *c* of a circle into two sections *a* and *b*, such that $c = a + b$ and $c/a = a/b$. The Golden Angle principle applied to PROPELLER MRI enables a particularly isotropic distribution of corrupted k-space blades over the circle spanned by the rotated blades and, thus, a minimization of motion-induced artifacts in the finally reconstructed MR image. By incrementing the rotation angle by the Golden Angle an isotropic, increasingly dense angular coverage of the circle is achieved. For the diametric PROPELLER blades, only a semicircle has to be considered, which results in a rotation increment of the half Golden Angle.

In a practical example, the rotation angle of the k-space blades is selected according to the formula $\varphi(i) = f(i)\cdot180°/N$ or $\varphi(i) = f(i)\cdot180°\cdot(1+1/N)$, wherein $i = 1,2,...$ *N* represents an index of the consecutively acquired k-space blades, and $f(i)$ represents a function that maps the index *i* to an integral number between 0 and *N* -1 such that the rotation angle increment $\varphi(i+1)-\varphi(i)$ is larger than 180°/*N*. As a consequence of the infinite sequence period resulting from the Golden Angle increment, the blade arrangement within the circle spanned by the k-space blades is slightly asymmetric. However, in a typical PROPELLER acquisition, the number of k-space blades is fixed, making a symmetric arrangement of blades more preferable. This can be achieved by the above formula. The function $f(i)$ is chosen such that the above-described interleaved arrangement results, wherein the angles $\varphi(i)$ approximate the Golden Angle (or the half Golden Angle) as closely as possible. In case the formula $\varphi(i) = f(i)\cdot180°/N$ applies, the readout gradient rotates about 180° during one acquisition. If the rotation angle is determined by the formula $\varphi(i) = f(i)\cdot180°\cdot(1+1/N)$, the readout gradient rotates about 360° during each acquisition.

According to still a further aspect which does also not form part of the present invention, a device for MRI of a body placed in an examination volume is disclosed, wherein the device comprises means for establishing a substantially homogeneous main magnetic field in the examination volume, means for generating switched magnetic field gradients superimposed upon the main magnetic field, means for radiating RF pulses towards the body, control means for controlling the generation of the magnetic field gradients and the RF pulses, means for receiving and sampling MR signals, and reconstruction means for forming MR images from the signal samples. The invention proposes that the device is arranged to

a) generate a series of MR signals by subjecting at least a portion of the body to an MR imaging sequence of at least one RF pulse and switched magnetic field gradients,
b) acquire a plurality of k-space blades according to the PROPELLER scheme, the k-space blades being rotated about a center of k-space,
c) weight the acquired MR data, wherein weighting factors are computed on the basis of acquisition times for contrast manipulation, correlation measures for motion compensation, and on the basis of the geometry of the overlapping areas of the k-space blades, and
d) reconstruct an MR image from the acquired and weighted MR signals.

The features of this third aspect can advantageously be combined with the features of the above-described first and/or second aspects.

The essential feature of the third aspect is that the weighting factors used for the sampling density compensation are not computed by an iterative approach as in the conventional PROPELLER concept. Instead, the weighting factors are computed directly on the basis of various criteria, such as acquisition times depending on the chosen MR imaging pulse sequence (for example a TSE sequence) for the purpose of prioritization of MR signals acquired at certain echo times, correlation measures for the purpose of prioritization of the acquired k-space blades, and the geometry of the overlapping areas of the k-space blades for the purpose of sampling density compensation. Preferably, the weighting factors are additionally normalized prior to the final image reconstruction step.

The invention not only relates to a device but also to a method for MRI of at least a portion of a body placed in an examination volume of an MR device.

A computer program adapted for carrying out the imaging procedure of the invention can advantageously be implemented on any common computer hardware, which is presently in clinical use for the control of magnetic resonance scanners. The computer program can be provided on suitable data carriers, such as CD-ROM or diskette. Alternatively, it can also be downloaded by a user from an Internet server.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings

Fig. 1 shows an MR scanner according to the invention;
Fig. 2 illustrates the acquisition of an MR reference data set for PROPELLER MRI according to the invention;
Fig. 3 illustrates the k-space sampling scheme of PROPELLER MRI including the Golden Angle rotation of PROPELLER blades.

DETAILED DESCRIPTION OF THE EMBODIMENTS

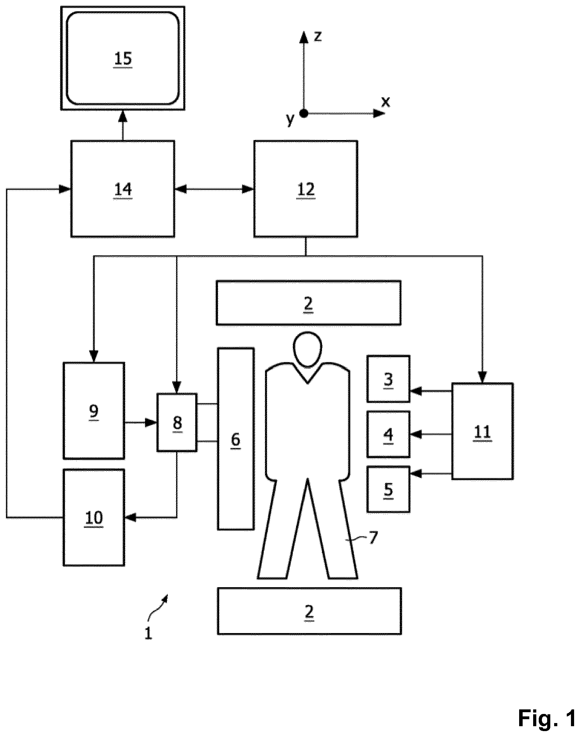

In Fig.1 an MR imaging device 1 in accordance with the present invention is shown as a block diagram. The apparatus 1 comprises a set of main magnetic coils 2 for generating a stationary and homogeneous main magnetic field and three sets of gradient coils 3, 4 and 5 for superimposing additional magnetic fields with controllable strength and having a gradient in a selected direction. Conventionally, the direction of the main magnetic field is labelled the z-direction, the two directions perpendicular thereto the x- and y-directions. The gradient coils 3, 4 and 5 are energized via a power supply 11. The imaging device 1 further comprises an RF transmit antenna 6 for emitting RF pulses to a body 7. The antenna 6 is coupled to a modulator 9 for generating and modulating the RF pulses. Also provided is a receiver for receiving the MR signals, the receiver can be identical to the transmit antenna 6 or be separate. If the transmit antenna 6 and receiver are physically the same antenna as shown in Fig. 1, a send-receive switch 8 is arranged to separate the received signals from the pulses to be emitted. The received MR signals are input to a demodulator 10. The send-receive switch 8, the modulator 9, and the power supply 11 for the gradient coils 3, 4 and 5 are controlled by a control system 12. Control system 12 controls the phases and amplitudes of the RF signals fed to the antenna 6. The control system 12 is usually a microcomputer with a memory and a program control. The demodulator 10 is coupled to reconstruction means 14, for example a computer, for transformation of the received signals into images that can be made visible, for example, on a visual display unit 15. For the practical implementation of the invention, the MR device 1 comprises a programming for executing an MRI PROPELLER scheme in the above-described manner.

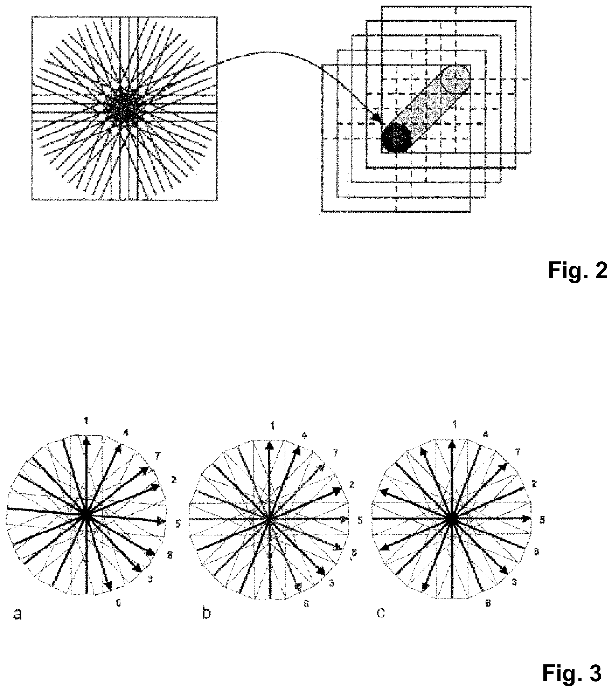

In Fig. 2, the acquisition of an MR reference data set for multi-slice PROPELLER MRI according to the invention is illustrated. The left diagram in Fig. 2 shows the acquisition of a plurality of k-space blades during the acquisition of a single image slice. The k-space blades are rotated about the center of k-space, so that the total acquired MR data set approximately spans a circle in k-space. In Fig. 2, the central portion of k-space acquired for each k-space blade is indicated as a black circle in the left diagram. Before the acquisition of the k-space blades, a three-dimensional low-resolution MR reference data set is acquired from the central portion of k-space indicated by the tubular central k-space region in the right diagram of Fig. 2. Multiple parallel image slices as also indicated in the right diagram of Fig. 2 are then acquired by the PROPELLER technique, and the MR data acquired from the central portion of k-space is compared to the MR reference data set for each k-space blade in order to estimate and correct motion-induced displacements and phase errors. Since the initial MR reference measurement covers the central portion of k-space of all image slices and (at least approximately) the central k-space portion of all PROPELLER blades, it can serve as a common reference for all k-space blades of the multi-slice acquisition. This approach ensures that no motion-induced misalignment of the image slices occurs during the multi-slice PROPELLER acquisition. The acquisition of the low-resolution MR reference data set takes approximately the same time as the acquisition of one single PROPELLER blade, which means that the technique of the invention minimizes the risk of motion during the acquisition of the MR reference data and does not significantly increase the total scan time.

Fig. 3 illustrates the k-space sampling of PROPELLER MRI according to an example not forming part of the present invention. Eight k-space PROPELLER blades are acquired. The blades are rotated about the center of k-space, so that the total acquired MR data set approximately spans a circle in k-space. The arrows shown in Fig. 3 indicate the directions of the readout magnetic field gradients generated for the respective k-space blades. In Fig. 3a, the rotation angle of the successively acquired k-space blades is incremented by the half Golden angle, which is approximately 68,75°. An isotropic, increasingly dense angular coverage of the circle is achieved in this way, which is also used e.g. by nature for the arrangement of leaves on a plant. The Golden Angle increment generates the interleaved arrangement of successive PROPELLER blades shown in Fig. 3a. As a result, motion-corrupted k-space blades are distributed uniformly over the circle spanned by the PROPELLER acquisition. Image artifacts are reduced as compared to conventional PROPELLER imaging, in which a linear order of consecutive k-space blades is applied. For the diametric PROPELLER blades, only a semicircle of rotation has to be considered. For this reason, the rotation angle increment can be the half Golden Angle instead of the full Golden Angle. The (half) Golden Angle increment results in an infinite sequence period and in a correspondingly asymmetric arrangement of the PROPELLER blades in k-space as can be seen in Fig. 3a. However, in a typical PROPELLER acquisition, the number of k-space blades is fixed. In order to achieve a symmetric arrangement of k-space blades, the Golden Angle blade order shown in Fig. 3a can simply be assigned to a symmetric order as shown in Fig. 3b. Here, the rotation angle of the $i$-th acquired k-space blade is determined by the formula $\varphi(i) = f(i) \cdot 180°/N$, wherein $f(i)$ represents a function that maps the index $i$ to an integral number between 0 and $N$-1 such that the desired order is obtained. For the depicted embodiment $f(i)$ can be tabulated as follows:

| $i$ | 1 | 2 | 3 | 4 | 5 | 6 | 7 | 8 |
|------|---|---|---|---|---|---|---|---|
| $f(i)$ | 0 | 3 | 6 | 1 | 4 | 7 | 2 | 5 |

As illustrated by the arrows in Fig. 3b, the readout gradient rotates about 180° during one acquisition in this case. The blade order shown in Fig. 3c is determined by the slightly modified formula $\varphi(i) = f(i) \cdot 180° \cdot (1 + 1/N)$. In this case, the readout gradient rotates about 360° during each acquisition.

As described herein before, another aspect not forming part of the present invention further proposes a direct approach to compute the weighting factors for sampling density compensation during the reconstruction of an MR image from the MR signals acquired by means of the PROPELLER technique. The approach combines geometry and prioritization considerations for the computation of the weighting factors. The conventional iterative approach, which is known to be slow and sporadically instable, is avoided. Thus, a very rapid and reliable data weighting procedure is obtained. The weighting factor for a signal sample $s$ in readout line $l$ and in k-space blade $b$ is initialized with

$$w_0(b,l,s) = w_D(l,s)w_C(b).$$

wherein $W_D$ denotes the weight derived from acquisition times for contrast weighting, which is usually independent of $b$. $w_C$ denotes the weight derived from correlation measures for (through-plane) motion correction, which is usually dependent on $b$ only. As a next step, the weights are added according to

$$w_1(b,l,s) = \sum_{p,q,r} w_0(p,q,r)d(p,q,r,b,l,s),$$

wherein $d(p,q,r,b,l,s)$ denotes a neighborhood indicator factor determined by the geometry of the overlapping areas of the PROPELLER blades. It is of course possible (and it may be necessary) to replace this summation by an appropriate form of interpolation. As a last step, a normalization of the weighting factors is optionally computed in accordance with the formula

$$w_2(b,l,s) = \frac{w_1(b,l,s)}{\left[EE^H w_1\right]_{(b,l,s)}},$$

wherein $E$ denotes the encoding matrix of the PROPELLER acquisition, i.e.

$$[E]_{mn} = e^{ik_m x_n}$$

with the k-space sampling positions $k_m$ and the pixel positions $x_n$, and $E^H$ the corresponding Hermitian. The normalization is preferably computed by applying gridding reconstruction or non-uniform fast Fourier transform principles.

**Claims**

1. Device for MR imaging of a body (7) placed in an examination volume of the device, the device (1) comprising:

means (2) for establishing a substantially homogeneous main magnetic field in the examination volume,
means (3, 4, 5) for generating switched magnetic field gradients superimposed upon the main magnetic field,
means (6) for radiating RF pulses towards the body (7),
control means (12) for controlling the generation of the magnetic field gradients and the RF pulses,
means (10) for receiving and sampling MR signals, and
reconstruction means (14) for forming MR images from the signal samples, the device (1) being arranged to

a) generate a series of MR signals by subjecting at least a portion of the body (7) to an MR imaging sequence of at least one RF pulse and switched magnetic field gradients,
b) acquire, separately from the acquisition defined in step c), an MR reference data set from a central portion of k-space, wherein the MR reference data set is a three-dimensional volume data set, this three-dimensional volume data set covering the central portion of k-space of two or more parallel image slices,
c) acquire a plurality of k-space blades according to the PROPELLER scheme, the k-space blades being rotated about a center of k-space, wherein at least a part of said central portion of k-space is acquired for each k-space blade, wherein the k-space blades are acquired for the two or more parallel image slices which are spaced in a direction perpendicular to the plane of rotation of the k-space blades,

d) compare the MR data acquired in step c) to the MR reference data set in said central portion of k-space for each k-space blade in order to estimate motion-induced displacements and phase errors, correct the MR signals for these motion-induced displacements and phase errors, and

e) reconstruct an MR image from the acquired and corrected MR signals.

2. Method for MR imaging of at least a portion of a body placed in an examination volume of an MR device, the method comprising the following steps:

a) generating a series of MR signals by subjecting at least a portion of the body to an MR imaging sequence of at least one RF pulse and switched magnetic field gradients,

b) acquiring, separately from the acquisition defined in step c), an MR reference data set from a central portion of k-space, wherein the MR reference data set is a three-dimensional volume data set, this three-dimensional volume data set covering the central portion of k-space of two or more parallel image slices,

c) acquiring a plurality of k-space blades according to the PROPELLER scheme from the two or more parallel image slices, the k-space blades being rotated about a center of k-space, wherein at least a part of said central portion of k-space is acquired for each k-space blade, wherein the two or more parallel image slices are spaced in a direction perpendicular to the plane of rotation of the k-space blades,

d) comparing the MR data acquired in step c) to the MR reference data set in said central area of k-space for each k-space blade in order to estimate motion-induced displacements and phase errors, correcting the MR signals for these motion-induced displacements and phase errors, and

e) reconstructing an MR image from the acquired and corrected MR signals.

3. Computer program for an MR device, the program comprising instructions which, when the program is executed by a computer of the MR device, cause the MR device to carry out the method of claim 2.

**Patentansprüche**

1. Vorrichtung zur MR-Abbildung eines Körpers (7), der in einem Untersuchungsvolumen der Vorrichtung platziert ist, die Vorrichtung (1) umfassend:

Mittel (2) zum Errichten eines im Wesentlichen homogenen Hauptmagnetfeldes im Untersuchungsvolumen,
Mittel (3, 4, 5) zum Generieren geschalteter Magnetfeldgradienten, die auf das Hauptmagnetfeld überlagert sind,
Mittel (6) zum Ausstrahlen von RF-Pulsen zum Körper (7),
Steuermittel (12) zum Steuern des Generierens der Magnetfeldgradienten und der RF-Pulse,
Mittel (10) zum Empfangen und Abtasten von MR-Signalen und
Rekonstruktionsmittel (14) zum Bilden von MR-Bildern aus den Signalabtastungen, wobei die Vorrichtung (1) angeordnet ist zum

a) Generieren einer Reihe von MR-Signalen durch Unterziehen zumindest eines Teils des Körpers (7) einer MR-Abbildungssequenz aus zumindest einem RF-Puls und geschalteten Magnetfeldgradienten,

b) Erlangen, separat von dem in Schritt c) definierten Erlangen, eines MR-Referenzdatensatzes aus einem zentralen Teil eines k-Raums, wobei der MR-Referenzdatensatz ein dreidimensionaler Volumendatensatz ist, wobei dieser dreidimensionale Volumendatensatz den zentralen Teil von k-Raum von zwei oder mehr parallelen Bildschnitten abdeckt,

c) Erlangen einer Vielzahl von k-Raum-Blades gemäß dem PROPELLER-Schema, wobei die k-Raum-Blades um einen k-Raum-Mittelpunkt gedreht werden, wobei zumindest ein Teil des zentralen Teils von k-Raum für jedes k-Raum-Blade erlangt wird, wobei die k-Raum-Blades für die zwei oder mehr parallelen Bildschnitte erlangt werden, die in einer Richtung senkrecht zur Drehebene der k-Raum-Blades beabstandet sind,

d) Vergleichen der MR-Daten, die in Schritt c) erlangt wurden, mit dem MR-Referenzdatensatz in dem zentralen Teil von k-Raum für jedes k-Raum-Blade, um bewegungsinduzierte Verschiebungen und Phasenfehler zu schätzen, Korrigieren der MR-Signale auf diese bewegungsinduzierten Verschiebungen und Phasenfehler, und

e) Rekonstruieren eines MR-Bildes aus den erlangten und korrigierten MR-Signalen.

**2.** Verfahren zur MR-Abbildung zumindest eines Teils eines Körpers, der in einem Untersuchungsvolumen einer MR-Vorrichtung platziert ist, das Verfahren umfassend die folgenden Schritte:

a) Generieren einer Reihe von MR-Signalen durch Unterziehen zumindest eines Teils des Körpers einer MR-Abbildungssequenz aus zumindest einem RF-Puls und geschalteten Magnetfeldgradienten,

b) Erlangen, separat von dem in Schritt c) definierten Erlangen, eines MR-Referenzdatensatzes aus einem zentralen Teil eines k-Raums, wobei der MR-Referenzdatensatz ein dreidimensionaler Volumendatensatz ist, wobei dieser dreidimensionale Volumendatensatz den zentralen Teil von k-Raum von zwei oder mehr parallelen Bildschnitten abdeckt,

c) Erlangen einer Vielzahl von k-Raum-Blades gemäß dem PROPELLER-Schema aus den zwei oder mehr parallelen Bildschnitten, wobei die k-Raum-Blades um einen k-Raum-Mittelpunkt gedreht werden, wobei zumindest ein Teil des zentralen Teils von k-Raum für jedes k-Raum-Blade erlangt wird, wobei die zwei oder mehr parallelen Bildschnitte in einer Richtung senkrecht zur Drehebene der k-Raum-Blades beabstandet sind,

d) Vergleichen der MR-Daten, die in Schritt c) erlangt wurden, mit dem MR-Referenzdatensatz in dem zentralen Teil von k-Raum für jedes k-Raum-Blade, um bewegungsinduzierte Verschiebungen und Phasenfehler zu schätzen, Korrigieren der MR-Signale auf diese bewegungsinduzierten Verschiebungen und Phasenfehler, und

e) Rekonstruieren eines MR-Bildes aus den erlangten und korrigierten MR-Signalen.

**3.** Computerprogramm für eine MR-Vorrichtung, das Programm umfassend Anweisungen, die, wenn das Programm durch einen Computer der MR-Vorrichtung ausgeführt wird, die MR-Vorrichtung veranlassen, das Verfahren nach Anspruch 2 durchzuführen.

**Revendications**

**1.** Dispositif pour l'imagerie RM d'un corps (7) placé dans un volume d'examen du dispositif, le dispositif (1) comprenant :

des moyens (2) pour établir un champ magnétique principal sensiblement homogène dans le volume d'examen,
des moyens (3, 4, 5) pour produire des gradients de champ magnétiques commutés superposés sur le champ magnétique principal,

des moyens (6) pour émettre des impulsions RF vers le corps (7),
des moyens de commande (12) pour commander la production des gradients de champ magnétiques et les impulsions RF,
des moyens (10) pour recevoir et échantillonner des signaux RM, et
des moyens de reconstruction (14) pour former des images RM à partir des échantillons de signal, le dispositif (1) étant agencé pour

a) produire une série de signaux RM en soumettant au moins une portion du corps (7) à une séquence d'imagerie RM d'au moins une impulsion RF et de gradients de champ magnétique commutés,
b) acquérir, séparément de l'acquisition définie dans l'étape c), un ensemble de données de référence RM à partir d'une portion centrale d'espace des k, dans lequel l'ensemble de données de référence RM est un ensemble de données de volume tridimensionnel, cet ensemble de données de volume tridimensionnel couvrant la portion centrale d'espace des k de deux tranches d'image parallèles ou plus,
c) acquérir une pluralité de lames d'espace des k selon le système PROPELLER, les lames d'espace des k étant mises en rotation autour d'un centre d'espace des k, dans lequel au moins une partie de ladite portion centrale d'espace des k est acquise pour chaque lame d'espace des k, dans lequel les lames d'espace des k sont acquises pour les deux tranches d'image parallèles ou plus qui sont espacées dans une direction perpendiculaire au plan de rotation des lames d'espace des k,
d) comparer les données RM acquises dans l'étape c) à l'ensemble de données de référence RM dans ladite portion centrale d'espace des k pour chaque lame d'espace des k pour évaluer des déplacements et des erreurs de phase induits par mouvement, corriger les signaux RM pour ces déplacements et erreurs de phase induits par mouvement, et
e) reconstruire une image RM à partir des signaux RM acquis et corrigés.

**2.** Procédé pour l'imagerie RM d'au moins une portion d'un corps placé dans un volume d'examen d'un dispositif RM, le procédé comprenant les étapes suivantes :

a) la production d'une série de signaux RM en soumettant au moins une portion du corps à une séquence d'imagerie RM d'au moins une impulsion RF et de gradients de champ magnétique commutés,

b) l'acquisition, séparément de l'acquisition définie dans l'étape c), d'un ensemble de données de référence RM à partir d'une portion centrale d'espace des k, dans lequel l'ensemble de données de référence RM est un ensemble de données de volume tridimensionnel, cet ensemble de données de volume tridimensionnel couvrant la portion centrale d'espace des k de deux tranches d'image parallèles ou plus,

c) l'acquisition d'une pluralité de lames d'espace des k selon le système PROPELLER à partir des deux tranches d'image parallèles ou plus, les lames d'espace des k étant mises en rotation autour d'un centre d'espace des k, dans lequel au moins une partie de ladite portion centrale d'espace des k est acquise pour chaque lame d'espace des k, dans lequel les deux tranches d'image parallèles ou plus sont espacées dans une direction perpendiculaire au plan de rotation des lames d'espace des k,

d) la comparaison des données RM acquises dans l'étape c) à l'ensemble de données de référence RM dans ladite zone centrale d'espace des k pour chaque lame d'espace des k afin d'évaluer des déplacements et erreurs de phase induits par mouvement, la correction des signaux RM pour ces déplacements et erreurs de phase induits par mouvement, et

e) la reconstruction d'une image RM à partir des signaux RM acquis et corrigés.

3. Programme informatique pour un dispositif RM, le programme comprenant des instructions qui, lorsque le programme est exécuté par un ordinateur du dispositif RM, amènent le dispositif RM à effectuer le procédé selon la revendication 2.

**Fig. 1**

**Fig. 2**

**Fig. 3**

**EP 2 806 284 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070001672 A1

**Non-patent literature cited in the description**

- **JAMES G. PIPE.** Motion Correction With PROPELLER MRI: Application to Head Motion and Free-Breathing Cardiac Imaging. *Magnetic Resonance in Medicine,* 1999, vol. 42, 963-969
- **CHUANG et al.** *Proc. ISMRM,* 2006, 295
- **JI et al.** *IEEE EMBS,* 2003, 478-481
- **MACLAREN et al.** TRELLIS MRI: A Novel Approach to Motion Correction. *Proc. ISMRM,* 2006, 3194
- **PIPE et al.** *Proc. ISMRM,* 2001, 743
- **ARFANAKIS et al.** *Magn. Reson. Med.,* 2005, 675-683
- **PIPE et al.** *Proc. ISMRM,* 2005, 2239